# EUROPEAN PATENT APPLICATION

(11) **EP 4 718 972 A1**
(43) Date of publication of application: **01.04.2026**
(21) Application number: 25194738.8
(22) Date of filing: 08.08.2025
(51) Int. Cl.: H10B 53/30, G11C 11/22, H10B 63/00, H10B 53/20

(54) **MEMORY USING FERROELECTRIC OR ANTIFERROELECTRIC CAPACITORS AND DIODES IN STACKED CONFIGURATIONS**

(30) Priority: 27.09.2024 US 202418900295
(71) Applicant: INTEL Corporation, Santa Clara, CA 95054 (US)
(72) Inventor: Chang, Sou-Chi, Portland, OR 97229 (US); Avci, Uygar, Portland, OR 97225 (US); Liao, Yu-Ching, Portland, OR 97229 (US); Karpov, Ilya, Portland, OR 97229 (US); Lin, Chia-Ching, Portland, OR 97229 (US); Choe, Gihun, Hillsboro, OR 97123 (US)
(74) Representative: Samson & Partner Patentanwälte mbB

(57) **Abstract**

An integrated circuit die includes a first surface having conductive features and a second surface opposite the first surface. A device layer is proximate the first surface and includes a plurality of transistors. The device layer is between a memory layer and the first surface. The memory layer includes memory circuitry having a plurality of memory cells memory cells arranged in a cross-bar array. Each memory cell comprises first and second diodes, and a capacitor. Each diode includes an insulator material between electrodes. In some embodiments, the first and second diodes share an electrode. The capacitor includes a ferroelectric or an antiferroelectric material between electrodes.

## Description

### BACKGROUND

Memory circuitry and processing or other logic circuitry may be fabricated on the same integrated circuit (IC) die or chip. In comparison to systems in which memory and processing circuitry are in separate chips, the integration of both memory and processing logic proximate to one another in the same IC chip can provide improved performance. For example, communication between the memory and the processor in an IC die with embedded memory may be at higher bandwidths and/or lower access latencies relative to packaged IC chips communicating through package interconnects.

One embedded memory architecture is based on memory cells that include a selector and a capacitor. The selector may be one or more transistors or other devices. The capacitor may be a conventional type having two electrodes separated by a dielectric material. However, an embedded memory may employ capacitors in which the dielectric material is replaced with a ferroelectric (FE or F) or anti- ferroelectric (AFE or AF) material. A memory using FE/AFE capacitors may provide faster access and use less power as compared a memory using conventional capacitors.

Implementing an embedded memory with memory cells that include transistor selectors and FE/AFE capacitors presents several challenges. In cache-level memory with memory cells based on a one transistor-one capacitor (1T-1F or 1T-1AF) design, back-end-of-line (BEOL) transistors may require a complex and expensive process to fabricate, and/or may result in thermally unstable memory cells. In addition, some architectures include memory cells that have multiple capacitors, e.g., 1T-4F. Multiple capacitor architectures require strict disturb immunity, which may limit the functionality as well as access latency these architectures can achieve for cache-level memory.

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Views referred to as "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure. Further, where considered appropriate, reference labels have been repeated among the figures to indicate corresponding or analogous elements. In the figures:
FIG. 1A illustrates a schematic of an integrated circuit (IC) with memory circuitry having a plurality of memory cells in accordance with some embodiments;
FIG. 1B illustrates a schematic of the memory cells and memory access lines of memory circuitry of FIG. 1A, in accordance with some embodiments;
FIGS. 2A and 2B are cross-sectional illustrations of example IC dies including memory circuitry having memory cells arranged in a cross-bar array, each memory cell comprising two diodes and a ferroelectric (FE) or anti-ferroelectric (AFE) capacitor, in accordance with some embodiments;
FIG. 3A is a cross-sectional illustration of a memory cell that includes first and second diodes and an FE or AFE capacitor, and FIG. 3B is a schematic illustration of the memory cell of FIG. 3A, in accordance with some embodiments;
FIG. 4 is a cross-sectional illustration of a memory cell that includes first and second diodes and an FE or AFE capacitor, in accordance with some embodiments;
FIG. 5 is a cross-sectional illustration of a memory cell that includes first and second diodes and an FE or AFE capacitor, in accordance with some embodiments;
FIG. 6 is a cross-sectional illustration of a memory cell that includes first and second diodes and an FE or AFE capacitor, in accordance with some embodiments;
FIG. 7 is a cross-sectional illustration of a memory cell that includes first and second diodes and an FE or AFE capacitor, in accordance with some embodiments;
FIG. 8A is a cross-sectional illustration of a memory cell that includes first and second diodes and an FE or AFE capacitor, in accordance with some embodiments;
FIG. 8B is a cross-sectional illustration of an alternative diode that may be substituted into any of the memory cells described herein, in accordance with some embodiments;
FIG. 9 illustrates a mobile computing platform and a data server machine employing one or more IC die with memory circuitry having memory cells arranged in a cross-bar array, the memory cells having first and second diodes, and a capacitor that includes FE or AFE material between electrodes, in accordance with some embodiments; and
FIG. 10 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

Front-end-of-line (FEOL) semiconductor processing and structures refer to stages of IC fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires). FEOL fabrication stages may precede BEOL fabrication stages.

Back end of line (BEOL) semiconductor processing and structures refer stages of IC fabrication where the individual devices (e.g., transistors, capacitors, resistors, etc.) become interconnected with wiring on the wafer, e.g., the metallization or dielectric layers. BEOL includes contacts, insulating layers (dielectrics), metal levels, and bonding sites for chip-to-package connections. In the BEOL fabrication stages, contacts (pads), interconnect wires, vias and dielectric structures are formed. For modern IC processes, more than 10 metal layers may be added in the BEOL.

Embodiments described herein are directed to a RAM-type non-volatile memory that includes ferroelectric (FE) or anti-ferroelectric (AFE) capacitors. In these types of memory, the dielectric material in the capacitor is replaced with a ferroelectric or antiferroelectric material. When a voltage is applied to the capacitor, an electric field is created and the material becomes polarized. When the electric field is removed, the material remains polarized. Two states of polarization, corresponding with the digital values of "1" and "0," are possible. The state of polarization is determined by the electric field, i.e., the applied voltage. For example, application of a first voltage +V across the capacitor causes a first polarization associated with a "1" and application of a second voltage -V causes a second polarization associated with a "0."

To store a digital value of "1" or "0" in a ferroelectric memory cell, a voltage is applied to the capacitor. To read the value stored in a ferroelectric memory cell, a voltage corresponding with a first polarization (and a first digital value) is applied to the capacitor while the quantity of electrical charge flowing to or from the capacitor is measured. The measured amount of charge is used to determine whether the voltage applied in the read operation changed the value stored in the capacitor. If the amount of charge required to place the capacitor in the first polarization state is below a threshold, the previous state of the cell corresponds with the first polarization state and the stored value equals the first digital value. If amount of charge required to place the capacitor in the first polarization state is above a threshold, the previous state of the cell corresponds with a second polarization state and the stored value equals a second digital value. Because a read operation destroys the memory cell state, it has to be followed by a write operation to restore the memory to its original state.

Embodiments described herein are directed to memory cells having BEOL-compatible diodes and FE or AFE capacitors. The memory cells are arranged in a cross-bar array. Since both the diodes and the FE/AFE capacitors are BEOL process compatible, the architecture is stackable with low-cost and potentially serves as ultimate high-density memory configurations.

An advantage of the described embodiments is that overall array density can be improved by simply stacking multiple layers of a cross-bar sub-array. In addition, the cost to fabricate is competitive because the diode selectors here are based on either metal/dielectric/metal layers or poly-crystalline P-N junctions. In addition, embodiments use two serially coupled diodes coupled at an "inner" node. A result of this two-diode selector design is that when write/read operation is performed at a memory cell, adjacent cells are not disturbed. The write/read disturb immunity is due to very low current from the reverse biasing and near-zero biasing of both diodes during read/write operation phase and bit storage phase, respectively, making the inner node close to ideal floating. In terms of array efficiency, this approach is also attractive as all the high-speed CMOS peripheral circuitry can be right underneath the array.

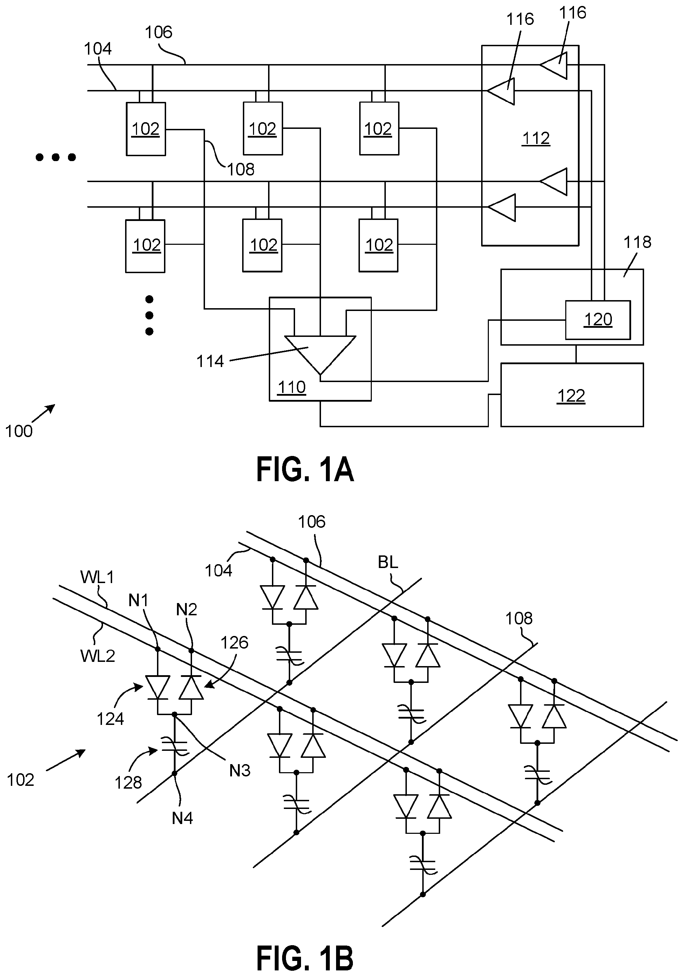

**FIG. 1A** illustrates a schematic of memory circuitry having a plurality of memory cells in an integrated circuit (IC) die in accordance with some embodiments. Memory circuitry 100 may be fabricated using back-end-of-line (BEOL) processes. In some embodiments, memory circuitry 100 is in the BEOL interconnect levels of an IC die. Advantageously, the array can be made denser than other designs simply by stacking multiple layers of memory cells in a cross-bar sub-array architecture. This is possible because devices in the memory cells in the memory array are based on BEOL processes.

Memory circuitry 100 includes plurality of memory cells 102 coupled with conductive traces including word lines 104 and 106, and bit lines 108. The conductive traces 104, 106, and 108 may be referred herein to as memory access lines. Memory circuitry 100 includes column circuitry 110 and row circuitry 112. Bit lines 108 may be electrically coupled to a sense amplifier 114 in column circuitry 110. Word lines 104 and 106 may be electrically coupled to drivers 116 in row circuitry 112. Memory circuitry 100 further includes control circuitry 118. Column circuitry 110 and row circuitry 112 may be electrically coupled to control circuitry 118. Control circuitry 118 may include circuitry 120 providing voltage biasing and memory management functions.

**FIG. 1A** also illustrates host logic circuitry 122 that may be included in an IC die. Host logic circuitry 122 uses data storage provided by memory circuitry 100. Host logic circuitry 122 may be CMOS peripheral circuitry located in a device layer of the IC die. In other examples, host logic circuitry 122 may be any application specific IC (ASIC) including one or more IP cores. In some embodiments, host logic circuitry 122 comprises a processor core.

**FIG. 1B** illustrates a schematic of memory cells 102 and memory access lines 104, 106, and 108 of memory circuitry 100, in accordance with some embodiments. Each memory cell 102 includes first and second diodes, and a capacitor. In some embodiments, the capacitor includes a ferroelectric (FE) material between a pair of electrodes, which may be referred to as a 2D-1F type memory cell. In some embodiments, the capacitor includes an antiferroelectric (AFE) material between a pair of electrodes, which may be referred to as a 2D-1 anti-F type memory cell.

Memory cells 102 may be arranged in a cross-bar array or matrix. Word lines 104 and 106 are arranged parallel to one another in a first direction, and bit lines 108 are arranged parallel to one another in a second direction orthogonal to the first direction. Connections to memory cells can be made at places where the word and bits lines cross. The word lines 104 and 106 may be fabricated in a layer adjacent to, e.g., over, a top side of the memory cells 102, while the bit lines 108 may be fabricated in a layer adjacent to, e.g., under, a bottom side of the memory cells 102. Thus, the cross-bar array of memory cells 102 may be a 3-D structure with memory cells 102 in one or more layers between memory access line layers.

In **FIG. 1B****,** in order to better illustrate how memory access lines are connected to cell nodes, one of the bit lines 108 is designated BL and two of the word lines 104 and 106 are respectively designated WL1 and WL2. As may be seen in FIG. 1B, memory cell 102 includes first diode 124, second diode 126, and an FE or AFE capacitor 128. The first diode 124 is connected between word line WL2 at node N1 and a node N3. The second diode 126 is connected between word line WL1 at node N2 and the node N3. The capacitor 128 is connected between node N3 and bit line BL at node N4.

It can be seen that the first diode 124 and second diode 126 are connected in series between WL2 and WL1. The first and second diodes 124, 126 function as a memory cell selector. To perform a read/write operation, the first and second diodes 124, 126 are forward biased. The diodes are forward biased by providing a differential voltage between WL1 and WL2, e.g., WL1 is set to +V volts while WL2 is set to 0 volts. After read/write operation, inner node N3 is set to zero by properly biasing WL1 and WL2. When the memory cell is in a data retention phase, zero biasing on WL1 and WL2 to make inner node floating and second diodes 124, 126. The first and second diodes may be in a first layer of the IC die.

The capacitor 128 may be in a capacitor layer of the IC die. Advantageously, the diodes may be fabricated at low cost because the diodes are formed from either metal/dielectric/metal layers or poly-crystalline PN junctions. An additional advantage of the use of a unipolar diode selector is that write/read operations do not disturb adjacent cells. This is due to very low current from zero and reversed bias of diodes during a storage phase, making inner node N3 floating. A further advantage is that high-speed CMOS peripheral circuitry can be fabricated underneath the memory array.

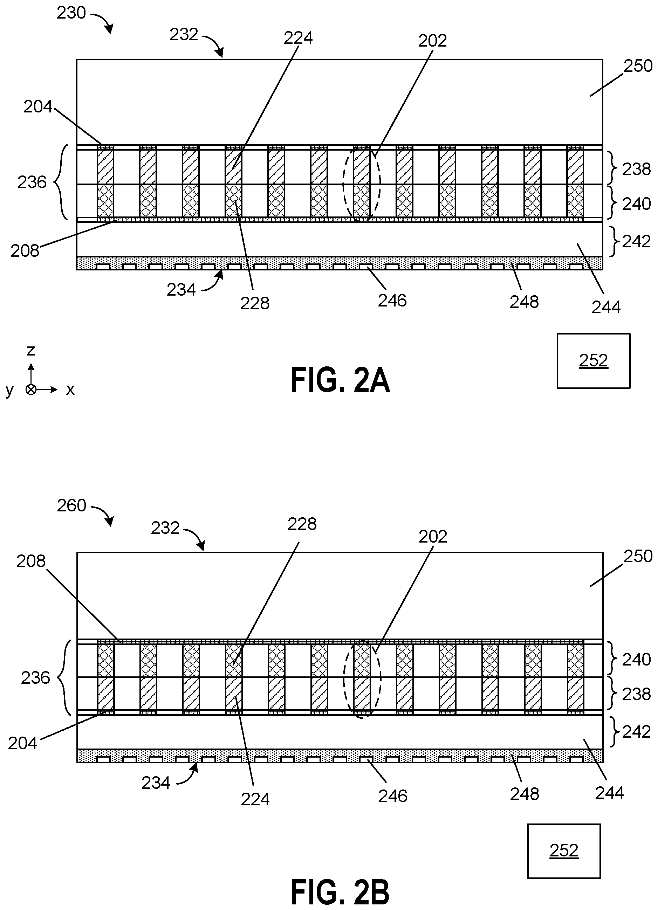

**FIGS. 2A and 2B** are cross-sectional illustrations of example IC dies including memory circuitry having memory cells 102 arranged in a cross-bar array, in accordance with some embodiments. Each memory cell 102 comprises two diodes and a ferroclectric or anti-ferroelectric capacitor. The same reference numbers used in the description of memory circuitry 100 and memory cells 102 used in FIGS. 1A and 1B are used to describe the same or similar features in other figures herein, including FIGS. 2A and 2B. FIG. 2A illustrates a cross-section of an IC die 230 and FIG. 2B illustrates a cross-section of an IC die 260. The layout of IC die 230 and IC die 260 may be employed in any integrated circuit device including dedicated memory devices, or in devices comprising logic or a processor, and an integrated memory.

IC die 230 and IC die 260 each include a first surface 234 and a second surface 232 opposite the first surface. First surface 234 may be at a "back side" and second surface 232 may be at a "front side" of the IC die. In some embodiments, the first surface includes conductive features 246 that are separated by a dielectric material 248. IC dies 230, 260 each include a device layer 242 proximate the first surface 234. The device layer 242 includes a plurality of transistors 244. For example, the device layer 242 may include CMOS peripheral circuitry. IC dies 230, 260 also each include a memory layer 236 over the device layer 242. The memory layer 236 includes memory circuitry, specifically, a plurality of memory cells 202, each memory cell having series-connected first and second diodes 224, and an FE or AFE capacitor 228. The first and second diodes 224 may be in a selector (or first) layer 238, while the FE or AFE capacitor 228 may be in a capacitor (or second) layer 240. The term "selector layer" is used for ease of reference and not to describe a characteristic, feature, or other attribute of layer 238. Similarly, the term "capacitor layer" is used for ease of reference and not to describe a characteristic, feature, or other attribute of layer 238. In various examples, word lines 204 are adjacent to the first and second diodes 224 in the selector layer 238. While shown in a distinct layer, the word lines 204 may be within selector layer 238 in some examples. The selector layer 238 may include metal features, and insulating or dielectric material. The selector layer 238 may also include any material suitable for the interfacial layers 314, 316 described herein. For example, selector layer 238 may include metal features, such as metal electrodes for diodes, metal vias, lateral metal lines, and dielectric material that surrounds and isolates the metal features. Selector layer 238 may include multiple layers, some of which contain metallization, some of which contain dielectric or insulating material, and some of which contain both metallization and dielectric or insulating material. In embodiments, bit lines 208 are adjacent to the capacitor 228 is in the capacitor layer 240. While shown in a distinct layer, the bit lines 208 may be within capacitor layer 240 in some examples. IC dies 230, 260 each include FEOL layers 250 proximate the second surface 232. The FEOL layers 250 may include metallization, dielectric, and any type of electronic devices, such as transistors.

In various embodiments, as shown in FIGS. 2A and 2B, the device layer 242 is between memory layer 236 and first surface 234 in both IC dies 230, 260. However, IC die 230 and IC die 260 differ with respect the relative positions of selector (or first) layer 238 and capacitor (or second) layer 240. In some examples, the first layer 238 is over the second layer 240, e.g., IC die 230. In other examples, the second layer 240 is over the first layer 238, e.g., IC die 260. Although only one memory layer 236 is illustrated, any number of layers 236 may be implemented in alternative embodiments.

FIGS. 2A and 2B also illustrate a power supply 252. The IC dies 230, 260 may attached and electrically coupled to a substrate, which in turn may include and/or be coupled with power supply 252. While various implementations are possible, the power supply 252 serves to power the memory circuitry and device circuitry within IC dies 230, 260.

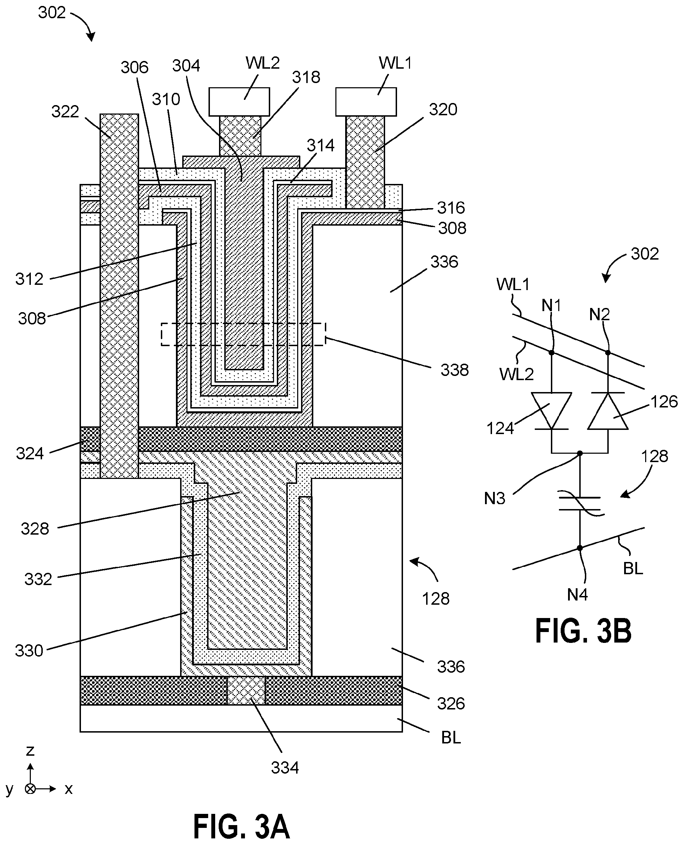

**FIG. 3A** is a cross-sectional illustration of a memory cell 302 that includes first and second diodes and an FE or AFE capacitor, in accordance with some embodiments. **FIG. 3B** illustrates a schematic of memory cell 302 and memory access lines WL1, WL2, and BL, in accordance with some embodiments. The same reference numbers used in the description of memory circuitry 100 and memory cells 102 are used in FIGS. 1A, 1B may be used to describe the same or similar features in other figures herein, including FIGS. 3A and 3B.

In the example memory cell 302, the first diode 124 includes a first insulator material 310 between a first electrode 304 and a "shared" electrode 306. The second diode 126 includes a second insulator material 312 between a second electrode 308 and the shared electrode 306. The first and second insulator material may comprise ZnO₂, Ga₂O₃, CeO₂, TiO₂, Al₂O₃, HfO₂, ZrO₂, SrTiO₃, SiO₂, La₂O₃, MgO, MgO, or SnO₂. The first, second, and shared electrodes may include titanium nitride or tungsten in some examples. In the schematic diagram of FIG. 3B, the shared electrode 306 corresponds with node N3. The shared electrode 306 includes a first interfacial layer 314 contacting first insulator material 310. The second electrode 308 includes a second interfacial layer 316 contacting the second insulator material 312. First and second interfacial layers 314, 316 provide a barrier for electron injection. First and second interfacial layers 314, 316 may comprise RuOₓ, IrOₓ, WOₓ, TiOₓ, or NbOₓ. First and second interfacial layers 314, 316 are at a surface of the electrodes and may have a thickness less than one or two (1 or 2) nanometers.

A diode has an anode (positive side) terminal and a cathode (negative side) terminal. In an MIM diode, the location of the interfacial layer determines diode polarity. For example, in FIG. 3A, the first diode 124 includes an anode (first electrode 304) and a cathode (shared electrode 306). The location of the first interfacial layer 314 between the first insulator material 310 and the shared electrode 306 determines that the shared electrode 306 is the cathode of the first diode 124. In FIG. 3A, the location of the second interfacial layer 316 between the second insulator material 312 and the second electrode 308 determines that the second electrode 308 is the cathode of the second diode 126.

In the examples provided herein illustrate serially connected diodes arranged with a particular polarity, i.e., the first and second interfacial layers are shown in a particular relation to the first and second electrodes, making one electrode an anode and the other a cathode. In alternative embodiments, in any of the examples provided herein, the locations of the first and second interfacial layers may be modified to reverse the polarity of the diodes in the example, provided that the serial arrangement in which the cathode of one diode is connected to the anode of the other diode is maintained.

The capacitor 128 includes FE or AFE material 332 between a third electrode 328 and a fourth electrode 330. A metal feature 322 extending vertically (z-direction) directly contacts shared electrode 306 and third electrode 328, electrically coupling the first and second diodes with the capacitor. FE or AFE material 332 may comprise hafnium, zirconium, or lanthanum. In some embodiments, FE or AFE material 332 includes hafnium doped with zirconium, where the proportion of zirconium may be adjusted to produce either an FE material or an AFE material. The third and fourth electrodes 328, 330 may comprise TiN, W, Mo, Nb, Ru, Ir, Au, or Pt material.

Memory cell 302 is coupled to word lines WL1 and WL2, and bit line BL by metal features that extend vertically. Specifically, first electrode 304 is coupled with WL2 by a metal feature 318 that contacts the word line and the electrode. Second electrode 308 is coupled with WL1 by a metal feature 320 that contacts the word line and the electrode. Fourth electrode 330 is coupled with BL by a metal feature 334 that contacts the bit line and the electrode. As mentioned, metal feature 322 couples shared electrode 306 in the selector layer and third electrode 328 in the capacitor layer. Metal features 318, 320, 322, and 334 may be tungsten in some embodiments. Memory access lines WL1 and WL2, and bit line BL may be copper.

An isolation layer 324 between first electrode 304 and third electrode 328 separates the selector layer, which contains the diode structure, from the capacitor layer. An isolation layer 326 below fourth electrode 330 separates the capacitor from structures below the capacitor, such as bit line BL. Isolation layers 324, 326 may be SiO2 or Si₃N₄ material. A dielectric material 336 adjacent to sides of the diodes and capacitor isolates the devices from other structures.

The diodes in the example memory cell 302 have a trench-like or U-shaped architecture with the first diode nested within the second diode enabling the sharing of an electrode. In FIG. 3A, a region 338 of the selector layer is shown enclosed with a dashed line. It will be appreciated that within region 338 a portion of the first electrode 304, a portion of the second electrode 308, and a portion of the shared electrode 306 are all in a same layer that may be defined by the z-height of region 338. In other words, a portion of the first electrode 304, a portion of the second electrode 308, and a portion of the shared electrode 306 are laterally (x-direction) adjacent to one another within region 338. Moreover, when the vertical and horizontal extents of the first electrode 304, the second electrode 308, and the shared electrode 306 are considered as a whole (i.e., portions both within and outside of region 338), the vertical portions of the electrodes are vertically adjacent and the horizontal portions are or laterally adjacent, as shown in FIG. 3A.

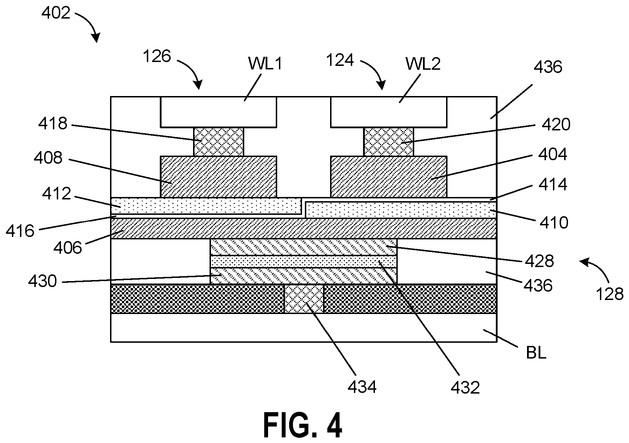

**FIG. 4** is a cross-sectional illustration of a memory cell 402 that includes first and second diodes and an FE or AFE capacitor, in accordance with some embodiments. The example memory cell 402 includes a first diode 124 that has a first insulator material 410 between a first electrode 404 and a shared electrode 406. A second diode 126 includes a second insulator material 412 between a second electrode 408 and shared electrode 406. The first, second, and shared electrodes include titanium nitride or tungsten in some examples. The first electrode 404 includes a first interfacial layer 414 contacting first insulator material 410. The shared electrode 406 includes a second interfacial layer 416 contacting the second insulator material 412. First and second interfacial layers 414, 416 are at a surface of the electrodes and may comprise the same materials and thicknesses of first and second interfacial layers 314, 316 described above.

In the example memory cell 402, the capacitor includes FE or AFE material 432 between a third electrode 428 and a fourth electrode 430. The FE or AFE material 432 may include hafnium and zirconium. In some embodiments, FE or AFE material 432 includes hafnium doped with zirconium. The ratio of zirconium to hafnium may be adjusted to produce either an FE material or an AFE material.

The diodes in the example memory cell 402 have a planar architecture with a shared electrode. In the example memory cell 402, the shared electrode 406 in the selector layer and the third electrode 428 in the capacitor layer are in direct contact. In other words, the shared electrode 406 is directly on the third electrode 428. In addition, the first and second electrodes 404, 408 may be on a same layer within the selector layer, as shown in FIG. 4. stated differently, the first and second electrodes 404, 408 may be laterally adjacent.

Memory cell 402 is coupled to word line WL2 by a metal feature 420 that contacts the word line WL2 and the first electrode 404. Memory cell 402 is coupled to word line WL1 by a metal feature 418 that contacts the word line WL1 and the second electrode 408. Memory cell 402 is coupled to bit line BL by a metal feature 434 that contacts the bit line BL and the fourth electrode 430. Metal features 418, 420, and 434 may be tungsten in some embodiments. A dielectric material 436 adjacent to sides of the diodes and capacitor isolates the devices from other structures.

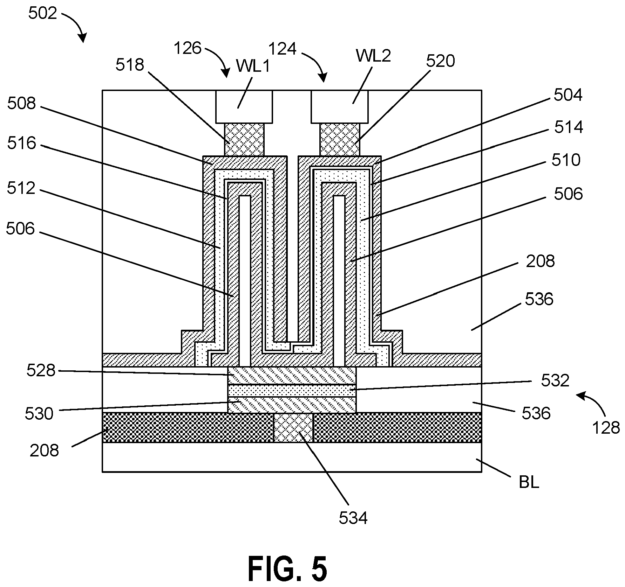

**FIG. 5** is a cross-sectional illustration of a memory cell 502 that includes first and second diodes and an FE or AFE capacitor, in accordance with some embodiments. The example memory cell 502 includes a first diode 124 that has a first insulator material 510 between a first electrode 504 and a shared electrode 506. A second diode 126 includes a second insulator material 512 between a second electrode 508 and shared electrode 506. The first, second, and shared electrodes include titanium nitride or tungsten in some examples. The first electrode 504 includes a first interfacial layer 514 contacting first insulator material 510. The shared electrode 506 includes a second interfacial layer 516 contacting the second insulator material 512. First and second interfacial layers 514, 516 are at a surface of the electrodes and may comprise the same materials and thicknesses of first and second interfacial layers 314, 316 described above.

In the example memory cell 502, the capacitor includes FE or AFE material 532 between a third electrode 528 and a fourth electrode 530. The FE or AFE material 532 may include hafnium and zirconium. In some embodiments, FE or AFE material 532 includes hafnium doped with zirconium. The proportion of zirconium may be adjusted to produce either an FE material or an AFE material.

The shared electrode 506 in the selector layer and the third electrode 528 in the capacitor layer are in direct contact. In other words, the shared electrode 506 is directly on the third electrode 528. In addition, the first and second electrodes 504, 508 may be in a same layer within the selector layer, as shown in FIG. 5. Stated differently, the first and second electrodes 504, 508 may be laterally adjacent.

The diodes in the example memory cell 502 have a fin-like or inverted-U-shaped architecture with a shared electrode. As such, vertical portions, e.g., sidewalls, of the first electrode 504 and the shared electrode 506 are horizontally adjacent. Similarly, vertical portions, e.g., sidewalls, of the second electrode 508 and the shared electrode 506 are horizontally adjacent. Further, at the top of the structure near the word lines, horizontal portions of the first electrode 504 and the shared electrode 506 are vertically adjacent. For example, the top side of shared electrode 506 is vertically adjacent to inner top surface of first electrode 504. Moreover, at the top of the structure near the word lines, horizontal portions of the second electrode 508 and the shared electrode 506 are vertically adjacent.

Memory cell 502 is coupled to word line WL2 by a metal feature 520 that contacts the word line WL2 and the first electrode 504. Memory cell 502 is coupled to word line WL1 by a metal feature 518 that contacts the word line WL1 and the second electrode 508. Memory cell 502 is coupled to bit line BL by a metal feature 534 that contacts the bit line BL and the fourth electrode 530. Metal features 518, 520, and 534 may be tungsten in some embodiments. A dielectric material 536 adjacent to sides of the diodes and capacitor isolates the devices from other structures.

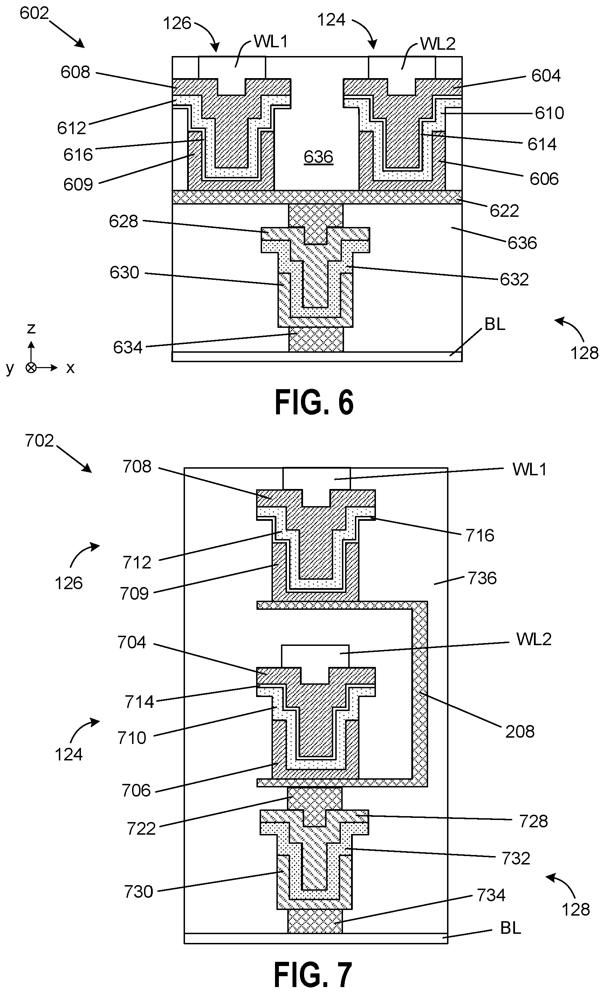

**FIG. 6** is a cross-sectional illustration of a memory cell 602 that includes first and second diodes and an FE or AFE capacitor, in accordance with some embodiments. The example memory cell 602 includes a first diode 124 that has a first insulator material 610 between a first electrode 604 and a second electrode 606. A second diode 126 includes a second insulator material 612 between a third electrode 608 and a fourth electrode 609. The first, second, third, and fourth electrodes include titanium nitride or tungsten in some examples. The first electrode 604 includes a first interfacial layer 614 contacting first insulator material 610. The fourth electrode 609 includes a second interfacial layer 616 contacting the second insulator material 612. First and second interfacial layers 614, 616 are at a surface of the electrodes and may comprise the same materials and thicknesses of first and second interfacial layers 314, 316 described above.

In the example memory cell 602, the capacitor includes FE or AFE material 632 between a fifth electrode 628 and a sixth electrode 630. The FE or AFE material 632 may include hafnium and zirconium. In some embodiments, FE or AFE material 632 includes hafnium doped with zirconium. The proportion of zirconium may be adjusted to produce either an FE material or an AFE material. A metal feature 622 extending vertically (z-direction) and horizontally (x-direction) directly contacts second and fourth electrodes 606, 609 and fifth electrode 628, electrically coupling the first and second diodes with the capacitor.

The diodes in the example memory cell 602 have a trench-like or U-shaped architecture. As such, a portion of the first electrode 604 and a portion of the second electrode 606 are laterally adjacent to one another. For example, a sidewall of first electrode 604 and a sidewall second electrode 606 are laterally adjacent to one another. In addition, a surface of first electrode 604 is vertically adjacent to a surface of the second electrode 606. For example, a bottom surface of first electrode 604 is vertically adjacent to the inner bottom surface of second electrode 606.

As shown in FIG. 6, word line WL2 may be in direct contact with the first electrode 604 and word line WL1 may be in direct contact with the third electrode 608, thereby coupling memory cell 602 with the word lines. Memory cell 602 may be coupled to bit line BL by a metal feature 634 that contacts the bit line BL and the sixth electrode 630. Metal feature 634 may be tungsten in some embodiments. A dielectric material 636 adjacent to sides of the diodes and capacitor isolates the devices from other structures.

**FIG. 7** is a cross-sectional illustration of a memory cell 702 that includes first and second diodes and an FE or AFE capacitor, in accordance with some embodiments. The example memory cell 702 includes a first diode 124 that has a first insulator material 710 between a first electrode 704 and a second electrode 706. A second diode 126 includes a second insulator material 712 between a third electrode 708 and a fourth electrode 709. The first, second, third, and fourth electrodes include titanium nitride or tungsten in some examples. The first electrode 704 includes a first interfacial layer 714 contacting first insulator material 710. The fourth electrode 709 includes a second interfacial layer 716 contacting the second insulator material 712. First and second interfacial layers 714, 716 are at a surface of the electrodes and may comprise the same materials and thicknesses of first and second interfacial layers 314, 316 described above.

In the example memory cell 702, the capacitor includes FE or AFE material 732 between a fifth electrode 728 and a sixth electrode 730. The FE or AFE material 732 may include hafnium and zirconium. In some embodiments, FE or AFE material 732 includes hafnium doped with zirconium. The proportion of zirconium may be adjusted to produce either an FE material or an AFE material. A metal feature 722 extending vertically (z-direction) and horizontally (x-direction) directly contacts the second electrode 706 and the fifth electrode 728. In addition, the metal feature 722 includes portions that extend horizontally in first direction, then vertically adjacent to the first diode, and finally horizontally in a second direction opposite the first direction to contact the fourth electrode 709, as shown in FIG. 7. The metal feature 722 contacts second electrode 706, fourth electrode 709, and fifth electrode 728, thereby electrically coupling the first and second diodes with the capacitor.

The diodes in the example memory cell 702 have a trench-like or U-shaped architecture. As such, a portion of the first electrode 704 and a portion of the second electrode 706 are laterally adjacent to one another. For example, a sidewall of first electrode 704 and a sidewall second electrode 706 are laterally adjacent to one another. In addition, a surface of first electrode 704 is vertically adjacent to a surface of the second electrode 706. For example, a bottom surface of first electrode 704 is vertically adjacent to the inner bottom surface of second electrode 706.

As shown in FIG. 7, word line WL2 may be in direct contact with the first electrode 704 and word line WL1 may be in direct contact with the third electrode 708, thereby coupling memory cell 702 with the word lines. Memory cell 702 may be coupled to bit line BL by a metal feature 734 that contacts the bit line BL and the sixth electrode 730. Metal feature 734 may be tungsten in some embodiments. A dielectric material 736 adjacent to sides of the diodes and capacitor isolates the devices from other structures.

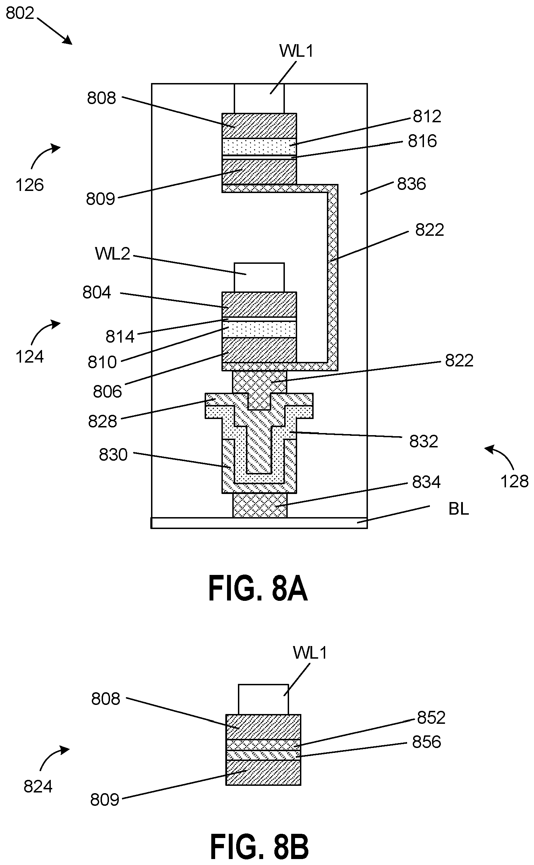

FIG. 8A is a cross-sectional illustration of a memory cell 802 that includes first and second diodes and an FE or AFE capacitor, in accordance with some embodiments. The example memory cell 802 includes a first diode 124 that has a first insulator material 810 between a first electrode 804 and a second electrode 806. A second diode 126 includes a second insulator material 812 between a third electrode 808 and a fourth electrode 809. The first, second, third, and fourth electrodes include titanium nitride or tungsten in some examples. The first electrode 804 includes a first interfacial layer 814 contacting first insulator material 810. The fourth electrode 809 includes a second interfacial layer 816 contacting the second insulator material 812. First and second interfacial layers 814, 816 are at a surface of the electrodes and may comprise the same materials and thicknesses of first and second interfacial layers 314, 316 described above.

In the example memory cell 802, the capacitor includes FE or AFE material 832 between a fifth electrode 828 and a sixth electrode 830. The FE or AFE material 832 may include hafnium and zirconium. In some embodiments, FE or AFE material 832 includes hafnium doped with zirconium. The proportion of zirconium may be adjusted to produce either an FE material or an AFE material. A metal feature 822 extending vertically (z-direction) and horizontally (x-direction) directly contacts the second electrode 806 and the fifth electrode 828. In addition, the metal feature 822 includes portions that extend horizontally in first direction, then vertically adjacent to the first diode, and finally horizontally in a second direction opposite the first direction to contact the fourth electrode 809, as shown in FIG. 8A. The metal feature 822 contacts second electrode 806, fourth electrode 809, and fifth electrode 828, thereby electrically coupling the first and second diodes with the capacitor.

The diodes in the example memory cell 802 have a planar architecture. As such, the first and second electrodes 804, 806 are in distinct layers and the first electrode 804 is over the second electrode 806. Similarly, the third and fourth electrodes 808, 809 are in distinct layers and the third electrode 808 is over the fourth electrode 809. In addition, the structure of the second diode 126 is over the first diode 124. In another aspect of the planar architecture, the first electrode 804 includes a first surface vertically adjacent to the second electrode 806, and the third electrode 808 includes a second surface vertically adjacent to the fourth electrode 809.

As shown in FIG. 8A, word line WL2 may be in direct contact with the first electrode 804 and word line WL1 may be in direct contact with the third electrode 808, thereby coupling memory cell 802 with the word lines. Memory cell 802 may be coupled to bit line BL by a metal feature 834 that contacts the bit line BL and the sixth electrode 830. Metal feature 834 may be tungsten in some embodiments. A dielectric material 836 adjacent to sides of the diodes and capacitor isolates the devices from other structures.

In some examples, the first and second diodes 124, 126 described in FIGS. 3-8 may be PN type diodes, rather than MIM type diodes. FIG. 8B is a cross-sectional illustration of a PN diode 824 that may be substituted into memory cell 802 to replace the first and second diodes 124, 126 illustrated in FIG. 2A, in accordance with some embodiments. The diode 824 comprises first material layers between first and second electrodes, wherein the first material layers includes a p-type polycrystalline semiconductor material layer 852, and an n-type polycrystalline semiconductor material layer 856. In some examples, p-type polycrystalline semiconductor material layer 852 comprises p-doped polycrystalline silicon. In some examples, n-type polycrystalline semiconductor material layer 856 comprises n-doped polycrystalline silicon. PN diodes (diodes with p-type and n-type material between electrodes) similar to PN diode 824 may be substituted into any of the memory cells described herein, in accordance with some embodiments.

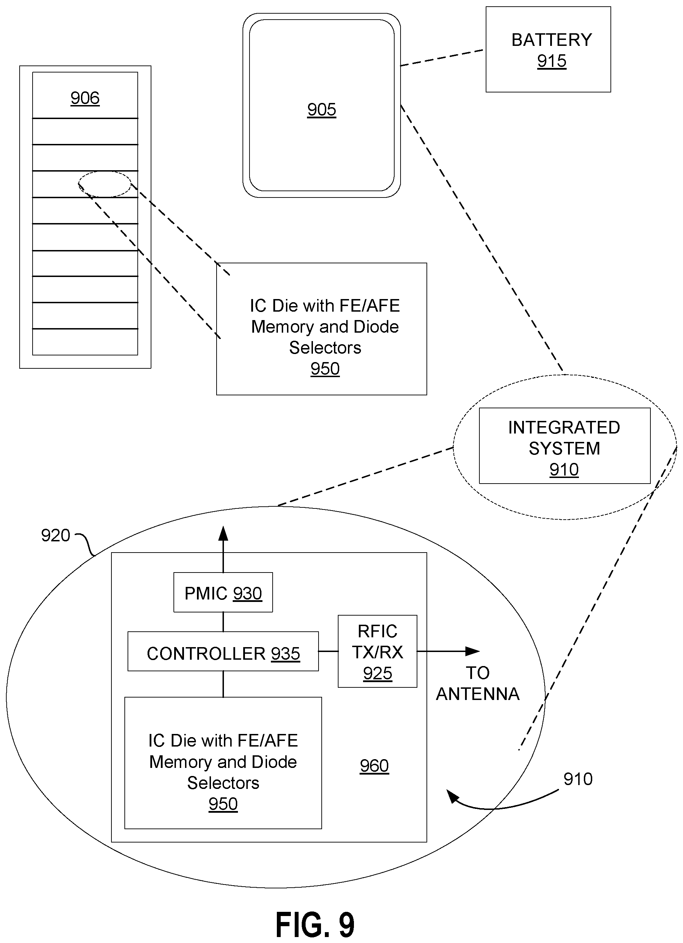

**FIG.** 9 illustrates a mobile computing platform and a data server machine employing one or more apparatus comprising an IC die 950 with memory circuitry arranged in a cross-bar array, the memory circuitry having memory cells having first and second diodes, and a capacitor that includes FE or AFE material between electrodes, for example as described elsewhere herein. Server machine 906 may be any commercial server, for example including any number of high-performance computing platforms disposed within a rack and networked together for electronic data processing. The mobile computing platform 905 may be any portable device configured for each of electronic data display, electronic data processing, wireless electronic data transmission, or the like. For example, the mobile computing platform 905 may be any of a tablet, a smart phone, laptop computer, etc., and may include a display screen (e.g., a capacitive, inductive, resistive, or optical touchscreen), a chip-level or package-level integrated system 910, and a battery 915.

Whether disposed within the integrated system 910 illustrated in the expanded view 920, or as a stand-alone package within the server machine 906, the IC die 950 with memory circuitry arranged in a cross-bar array, the memory circuitry having memory cells having first and second diodes, and a capacitor that includes FE or AFE material between electrodes, as described elsewhere herein. IC die 950 may be further coupled to a host substrate 960, along with, one or more of a power management integrated circuit (PMIC) 930, RF (wireless) integrated circuit (RFIC) 925 including a wideband RF (wireless) transmitter and/or receiver (TX/RX) (e.g., including a digital baseband and an analog front-end module further comprises a power amplifier on a transmit path and a low noise amplifier on a receive path), and a controller 935. PMIC 930 may perform battery power regulation, DC-to-DC conversion, etc., and so has an input coupled to battery 915 and with an output providing a current supply to other functional modules. As further illustrated, in the exemplary embodiment, RFIC 925 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 4G, and beyond.

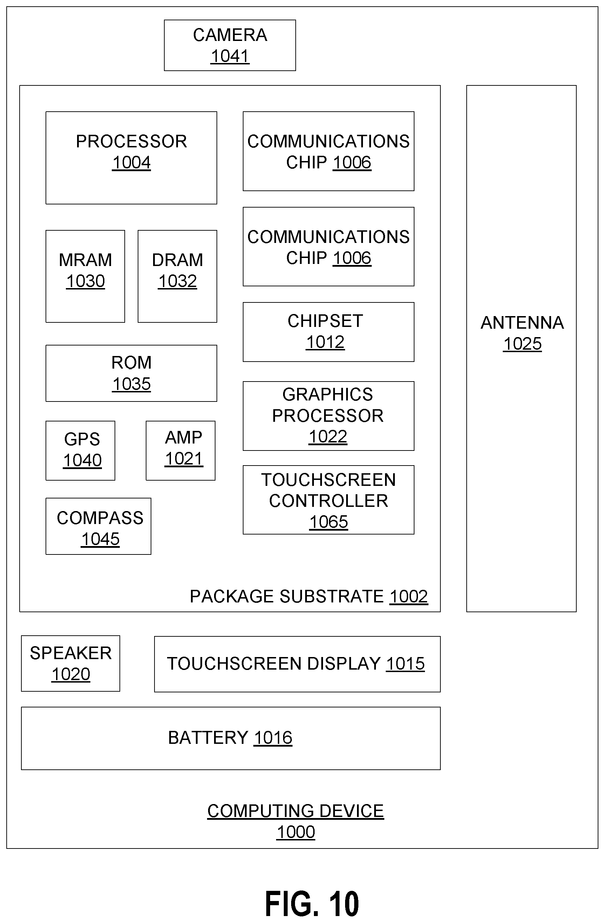

**FIG. 10** is a functional block diagram of an electronic computing device 1000, in accordance with an embodiment of the present invention. The computing device may be found inside mobile computing platform 905 or server machine 906, as described elsewhere herein. Device 1000 further includes a package substrate 1002 hosting a number of components, such as, but not limited to, a processor 1004 (e.g., an applications processor). Processor 1004 may be physically and/or electrically coupled to package substrate 1002. In general, the term "processor" or "microprocessor" may refer to any device or portion of a device that processes electronic data from registers and/or memory to transform that electronic data into other electronic data that may be further stored in registers and/or memory. In some examples, one or more of the components of computing device 1000 includes an IC die 950 with memory circuitry arranged in a cross-bar array, the memory cells having first and second diodes, and a capacitor that includes FE or AFE material between electrodes, as described elsewhere herein.

In various examples, one or more communication chips 1006 may also be physically and/or electrically coupled to the package substrate 1002. In further implementations, communication chips 1006 may be part of processor 1004. Depending on its applications, computing device 1000 may include other components that may or may not be physically and electrically coupled to package substrate 1002. These other components include, but are not limited to, volatile memory (e.g., DRAM 1032), non-volatile memory (e.g., ROM 1035), flash memory (e.g., NAND or NOR), magnetic memory (MRAM 1030), a graphics processor 1022, a digital signal processor, a crypto processor, a chipset 1012, an antenna 1025, touchscreen display 1015, touchscreen controller 1065, battery 1016, audio codec, video codec, power amplifier 1021, global positioning system (GPS) device 1040, compass 1045, accelerometer, gyroscope, speaker 1020, camera 1041, and mass storage device (such as hard disk drive, solid-state drive (SSD), compact disk (CD), digital versatile disk (DVD), and so forth), or the like..

Communication chips 1006 may enable wireless communications for the transfer of data to and from the computing device 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chip 1006 may implement any of a number of wireless standards or protocols. As discussed, computing device 1000 may include a plurality of communication chips 1006. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

Example 1: An integrated circuit (IC) die, comprising: a first surface comprising conductive features and a second surface opposite the first surface; memory circuitry comprising a plurality of memory cells, each memory cell comprising first and second diodes, and a capacitor, the capacitor comprising a ferroelectric (FE) or an antiferroelectric (AFE) material; a device layer proximate the first surface, the device layer comprising a plurality of transistors; and a memory layer over the device layer, the memory layer comprising the memory circuitry.

Example 2: The IC die of example 1, wherein the memory layer comprises a first layer and a second layer, the first and second diodes are in the first layer, the capacitor is in the second layer; and the first layer is over the second layer, or the second layer is over the first layer.

Example 3: The IC die of any of examples 1 or 2, further comprising first and second word lines proximate the first layer and a bit line proximate the second layer.

Example 4: The IC die of any of examples 1, 2, or 3, wherein: the first diode comprises a first insulator material between a first electrode and a shared electrode; the second diode comprises a second insulator material between a second electrode and the shared electrode; and the capacitor comprises the FE or AFE material between third and fourth electrodes.

Example 5: The IC die of example 4, further comprising a metal feature directly contacting the shared electrode and third electrode.

Example 6: The IC die of example 4, wherein the shared electrode is directly on the third electrode.

Example 7: The IC die of example 4, wherein a portion of the first electrode, a portion of the second electrode, and a portion of the shared electrode are all in a same layer.

Example 8: The IC die of example 4, wherein the first electrode and the second electrode are in a same layer over the shared electrode.

Example 9: The IC die of any of examples 1, 2, or 3, wherein: the first diode comprises a first insulator material between first and second electrodes; the second diode comprises a second insulator material between third and fourth electrodes; and the capacitor comprises the FE or AFE material between fifth and sixth electrodes.

Example 10: The IC die of example 9, wherein a portion of the first electrode and a portion of the second electrode are laterally adjacent to one another.

Example 11: The IC die of example 9, wherein: the first and second electrodes are in distinct layers and the second electrode is over the first electrode; and the third and fourth electrodes are in distinct layers and the fourth electrode is over the third electrode.

Example 12: The IC die of example 9, wherein the first diode is over the second diode.

Example 13: The IC die of any of examples 1, 2, or 3, wherein: the first diode comprises a first insulator material between first and second electrodes; the second diode comprises a second insulator material between third and fourth electrodes; the first electrode comprises a first interfacial layer contacting the first insulator material; the third electrode comprises a second interfacial layer contacting the second insulator material; and the first and second interfacial layers comprise a metal oxide.

Example 14: The IC die of any of examples 1, 2, 3, 4, or 9, wherein the FE material and the AFE comprise hafnium, zirconium, or lanthanum.

Example 15: The IC die of any of examples 1, 2, 3, 4, or 9, wherein the first diode comprises a first insulator material between first and second electrodes, and the first and second electrodes comprise titanium nitride or tungsten.

Example 16: The IC die of example 1, wherein: the first diode comprises first material layers between first and second electrodes, the first material layers comprising: a p-type polycrystalline semiconductor material layer, and an n-type polycrystalline semiconductor material layer; and the second diode comprises second material layers between third and fourth electrodes, the second material layers comprising: a p-type polycrystalline semiconductor material layer, and an n-type polycrystalline semiconductor material layer.

Example 17: An integrated circuit (IC) die, comprising: a device layer comprising a plurality of transistors; a memory array comprising a plurality of memory cells, each memory cell comprising: a first diode in a first layer comprising a first insulator material between a first electrode and a shared electrode, the first diode further comprising a first interfacial layer contacting the shared electrode; a second diode in the first layer comprising a second insulator material between a second electrode and the shared electrode, the second diode further comprising a second interfacial layer contacting the second electrode; and a capacitor comprising a ferroelectric or an antiferroelectric material in a second layer; and
wherein the device layer is between the first layer and the second layer and a surface of the IC die.

Example 18: The IC die of example 16, wherein a portion of the first electrode and a portion of the second electrode are laterally adjacent to one another.

Example 19: A system comprising: an integrated circuit (IC) die, comprising: memory circuitry comprising a plurality of memory cells, each memory cell comprising first and second diodes, and a capacitor, the capacitor comprising a ferroelectric (FE) or an antiferroelectric (AFE) material; a device layer comprising a plurality of transistors; a memory layer comprising the memory circuitry, wherein the device layer is between the memory layer and a surface of the IC die; and a power supply coupled to the IC die to power the IC die.

Example 20: The system of example 18, wherein: the first diode comprises first electrode and a shared electrode; the second diode comprises a second electrode and the shared electrode, wherein the shared electrode comprises a surface comprising a first portion adjacent to the first electrode and a second portion adjacent to the second electrode.

Example 21: The system of example 18, wherein: the first diode comprises first and second electrodes; the second diode comprises a third electrode and a fourth electrode, wherein the first electrode comprises a first surface horizontally adjacent to the second electrode, and the third electrode comprises a second surface horizontally adjacent to the fourth electrode.

## Claims

1. An integrated circuit (IC) die, comprising:
a first surface comprising conductive features and a second surface opposite the first surface;
memory circuitry comprising a plurality of memory cells, each memory cell comprising first and second diodes, and a capacitor, the capacitor comprising a ferroelectric (FE) or an antiferroelectric (AFE) material;
a device layer proximate the first surface, the device layer comprising a plurality of transistors; and
a memory layer over the device layer, the memory layer comprising the memory circuitry.

2. The IC die of claim 1, wherein the memory layer comprises a first layer and a second layer,
the first and second diodes are in the first layer, the capacitor is in the second layer; and
the first layer is over the second layer, or the second layer is over the first layer.

3. The IC die of claim 2, further comprising first and second word lines proximate the first layer and a bit line proximate the second layer.

4. The IC die of any of claims 1 to 3, wherein:
the first diode comprises a first insulator material between a first electrode and a shared electrode;
the second diode comprises a second insulator material between a second electrode and the shared electrode; and
the capacitor comprises the FE or AFE material between third and fourth electrodes.

5. The IC die of claim 4, further comprising a metal feature directly contacting the shared electrode and the third electrode.

6. The IC die of claim 4, wherein the shared electrode is directly on the third electrode.

7. The IC die of claim 4, wherein a portion of the first electrode, a portion of the second electrode, and a portion of the shared electrode are all in a same layer.

8. The IC die of claim 4, wherein the first electrode and the second electrode are in a same layer over the shared electrode.

9. The IC die of any of claims 1 to 3, wherein:
the first diode comprises a first insulator material between first and second electrodes;
the second diode comprises a second insulator material between third and fourth electrodes; and
the capacitor comprises the FE or AFE material between fifth and sixth electrodes.

10. The IC die of claim 9, wherein a portion of the first electrode and a portion of the second electrode are laterally adjacent to one another.

11. The IC die of claim 9, wherein:
the first and second electrodes are in distinct layers and the second electrode is over the first electrode; and
the third and fourth electrodes are in distinct layers and the fourth electrode is over the third electrode.

12. The IC die of any of claims 1 to 3, wherein:
the first diode comprises a first interfacial layer between a first cathode and a first insulator material;
the second diode comprises a second interfacial layer between a second cathode and a second insulator material; and
the first and second interfacial layers comprise a metal oxide.

13. The IC die of any of claims 1 to 4, or claim 9, wherein the FE material and the AFE comprise hafnium, zirconium, or lanthanum.

14. The IC die of any of claims 1 to 4, or claim 9, wherein:
the first diode comprises first material layers between first and second electrodes, the first material layers comprising:
a p-type polycrystalline semiconductor material layer, and
an n-type polycrystalline semiconductor material layer; and
the second diode comprises second material layers between third and fourth electrodes, the second material layers comprising:
a p-type polycrystalline semiconductor material layer, and
an n-type polycrystalline semiconductor material layer.

15. The IC die of any of claims 1 to 4, or claim 9, further comprising:
a system comprising:
the IC die, wherein the IC die comprises control circuitry and logic circuitry coupled with the memory circuitry; and
a power supply coupled to the system to power the IC die.
